Europäisches Patentamt

European Patent Office

Office européen des brevets

(11) Veröffentlichungsnummer: **0 277 691**
**A2**

# (12) EUROPÄISCHE PATENTANMELDUNG

(21) Anmeldenummer: 88200151.4

(22) Anmeldetag: 29.01.88

(51) Int. Cl.⁴: **H03D 7/12**

(30) Priorität: 05.02.87 DE 3703411

(43) Veröffentlichungstag der Anmeldung:
**10.08.88 Patentblatt 88/32**

(84) Benannte Vertragsstaaten:
**DE ES GB IT**

(71) Anmelder: **Philips Patentverwaltung GmbH
Wendenstrasse 35 Postfach 10 51 49
D-2000 Hamburg 1(DE)**

(84) **DE**

(71) Anmelder: **N.V. Philips' Gloeilampenfabrieken
Groenewoudseweg 1
NL-5621 BA Eindhoven(NL)**

(84) **ES GB IT**

(72) Erfinder: **Kupfer, Karl-Heinz
Krefelder Strasse 146
D-4150 Krefeld 29(DE)**

(74) Vertreter: **Kupfermann, Fritz-Joachim,
Dipl.-Ing. et al
Philips Patentverwaltung GmbH
Wendenstrasse 35 Postfach 10 51 49
D-2000 Hamburg 1(DE)**

(54) Schaltungsanordung zur Ankopplung eines Mischers an einen ZF-Oszillator.

(57) Bei einer Schaltungsanordnung für einen HF-Tuner zur Ankopplung eines Mischers, der eine induktive Eingangsimpedanz aufweist, an einen ZF-Oszillator, ist zur Dämpfung der Frequenzabhängigkeit des ZF-Oszillatorsignals am Eingang des Mischers vorgesehen, dem Mischer einen gegen Masse geschalteten ohmschen Widerstand vorzuschalten. Der Wert des Widerstandes wird so gewählt, daß sich infolge des Hinzuschaltens des ohmschen Widerstandes bei der höchsten Oszillatorfrequenz die am Eingang des Mischers anliegende Oszillatoramplitude etwa halbiert.

## Schaltungsanordnung zur Ankopplung eines Mischers an einen ZF-Oszillator

Die Erfindung bezieht sich auf eine Schaltungsanordnung für einen HF-Tuner, insbesondere Fernsehtuner, zur Ankopplung eines Mischers, der eine induktive Eingangsimpedanz aufweist, über eine Koppelkapazität an einen ZF-Oszillator.

In derartigen Schaltungsanordnungen stellt sich das Problem, daß die Amplitude des ZF-Oszillatorsignals am Eingang des Mischers von der jeweils eingestellten Frequenz des ZF-Oszillators abhängig ist. In dem Oszillator-Schwingkreis sind in der Regel zwei in Reihe geschaltete Kapazitäten vorgesehen, von denen eine veränderbar ist. Mittels dieser veränderbaren Kapazität wird die Schwingfrequenz eingestellt. Zwischen diesen beiden Kapazitäten wird das Oszillatorsignal ausgekoppelt. Dies geschieht im allgemeinen über eine Koppelkapazität, um den Oszillator-Schwingkreis nicht zu sehr zu belasten. Über diese Koppelkapazität wird das Signal dann dem Eingang eines Mischers zugeführt. Für Transistoren in Mischern wird üblicherweise eine Basisschaltung gewählt, so daß der Eingang des Mischers eine induktive Eingangsimpedanz aufweist.

Die zwischen den beiden in Reihe geschalteten Schwingkreiskapazitäten des Oszillators ausgekoppelte Oszillatorspannung weist an diesem Punkt noch eine von der Oszillatorfrequenz weitgehend unabhängige Amplitude auf. Infolge der Ankopplung des Oszillatorsignals über eine Serienkapazität an den induktiven Eingang des Mischers ergibt sich jedoch mit steigender Oszillatorfrequenz am Eingang des Mischers eine deutliche Erhöhung der Oszillatoramplitude. Hierbei überlagern sich zwei Effekte. Die Serienkapazität, über die das Oszillatorsignal aus dem Schwingkreis ausgekoppelt wird, wird mit steigenden Frequenzen immer niederohmiger. Zum anderen wird dieser Effekt noch unterstützt durch den induktiven Eingang des Mischers, der zu hohen Frequenzen hin hochohmiger wird. Dies führt dazu, daß die Amplitude am ZF-Mischer-Eingang bei der höchsten Abstimmfrequenz um ein Mehrfaches höher ist als bei der niedrigsten Abstimmfrequenz.

Es ist Aufgabe der Erfindung, eine Schaltungsanordnung für einen HF-Tuner der eingangs genannten Art anzugeben, die bei möglichst wirtschaftlichem Aufbau eine deutlich verringerte Abhängigkeit der ZF-Oszillatoramplitude von der Oszillatorfrequenz am Eingang des Mischers gewährleistet.

Diese Aufgabe ist erfindungsgemäß dadurch gelöst, daß hinter der Koppelkapazität dem Mischer-Eingang ein gegen Masse geschalteter ohmscher Widerstand vorgeschaltet ist, dessen Widerstandswert so gewählt ist, daß die am Eingang des Mischers anliegende Oszillator-Spannungsamplitude bei der höchsten Oszillatorfrequenz infolge des zugeschalteten Widerstandes etwa halbiert ist.

Wird am Eingang des Mischers vor der Koppelkapazität ein Widerstand gegen Masse geschaltet, dessen Wert so gewählt ist, daß die am Eingang des Mischers anstehende ZF-Oszillatoramplitude durch Hinzuschalten des Widerstandes sich bei der höchsten Abstimmfrequenz in etwa halbiert, wird die Gesamt-Eingangsimpedanz, die sich zusammensetzt aus der Eingangsimpedanz des Mischers und der Impedanz des ohmschen Widerstandes, deutlich weniger induktiv, so daß die Abhängigkeit des Eingangswiderstandes von der Frequenz abnimmt. Auf diese Weise kann durch Hinzuschalten eines Widerstandes die Abhängigkeit der Amplitude des Oszillatorsignals am Eingang des Mischers nennenswert verringert werden. Es kann in etwa ein Oszillator-Amplitudengang erreicht werden, bei dem die Amplitude bei der höchsten Abstimmfrequenz nur etwa doppelt so groß ist wie bei der niedrigsten Abstimmfrequenz. Dieses Verhältnis kann selbst dann noch eingehalten werden, wenn ein verhältnismäßig großer Frequenzsprung abzustimmen ist, beispielsweise bei den VHF-Bändern I und III.

Die Dimensionierung des Widerstandes bereitet insofern wenig Probleme, als bei derartigen Schatlungsanordnungen die Ausgangsimpedanz des Schwingkreises und des Oszillatortransistors relativ klein sind gegenüber den Koppekapazitäten 5 und 8, welche bei den gegebenen Frequenzen einen relativ hohen Widerstand aufweisen. Bei der Dimensionierung des Widerstandes spielt also die Ausgangsimpedanz des Schwingkreises und des Oszillatortransistors nur eine sehr geringe Rolle und ist im praktischen Falle gegenüber anderen Randbedingungen, wie z. B. Platinen-Lay-Out, zu vernachlässigen. Bei der Dimensionierung des Widerstandes sind also im wesentlichen nur die Werte der Koppelkapazitäten und die Eingangsimpedanz des Mischers zu berücksichtigen.

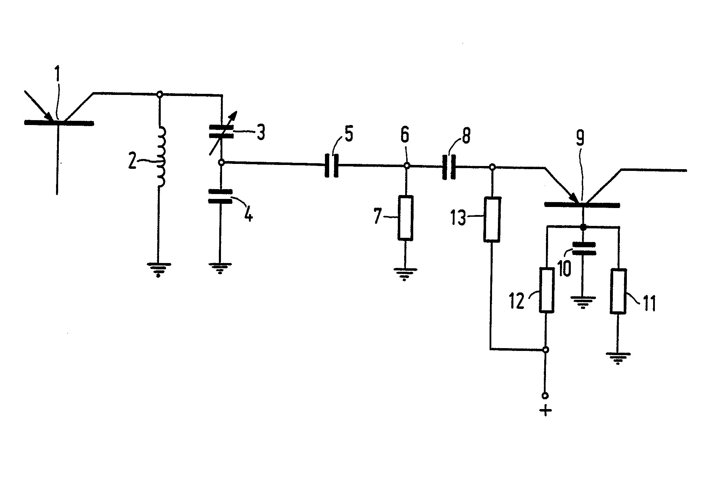

In der Figur ist eine Schaltungsanordnung für einen HF-Tuner zur Ankoppelung eines Mischers an einen ZF-Oszillator dargestellt.

Die Verschaltungen des ZF-Oszillators und des Mischers sind lediglich schematisch mit einigen Bauteilen dargestellt. Der ZF-Oszillator weist einen in Basisschaltung arbeitenden Transistor 1 auf, dessen Außenverschaltung in der Figur nicht näher dargestellt ist. Der Kollektor des Transistors 1 ist mit einer Parallelschaltung aus einer gegen Masse geführten Induktivität 2 und aus einer Reihenschaltung einer ersten veränderbaren Kapazität 3 und einer zweiten festen, gegen Masse geführten Kapazität 4 verbunden. Die Induktivität 2, die veränderbare Kapazität 3 und die feste Kapazität 4 bilden den Oszillator-Schwingkreis. Das ZF-Oszillatorsignal wird vom Verbindungspunkt der Kapazitäten 3 und 4 über einen Koppelkondensator 5 ausgekoppelt. Der Koppelkondensator ist mit seinem zweiten Anschluß mit einem Verbindungspunkt 6 verbunden, von dem aus ein ohmscher Widerstand 7 gegen Masse führt. Ferner ist der Eingang des Mischers über eine Koppelkapazität 8 mit dem Verbindungspunkt 6 verbunden. Der Mischer weist einen in Basisschaltung arbeitenden Transistor 9 auf, dessen Basis über eine Kapazität 10 mit Masse, über einen Widerstand 11 ebenfalls mit Masse und über einen Widerstand 12 mit der Spannungsversorgung verbunden ist. Ferner ist der Emitter des Transistors 9 mit der Koppelkapazität 8 und über einen Widerstand 13 mit der Spannungsversorgung verbunden.

Die Auskoppelung des ZF-Oszillatorsignals vom Verbindungspunkt der Kapazitäten 3 und 4 über die Koppelkapazität 5 hat eine relativ geringe Belastung des Oszillator-Schwingkreises zur Folge. Die Amplitude des Oszillatorsignals ist an dem Verbindungspunkt zwischen den Kapazitäten 3 und 4 noch relativ konstant und wenig von der eingestellten Frequenz des Schwingkreises abhängig. Dies hängt damit zusammen, daß bei relativ kleinen eingestellten Frequenzen die Kapazität 3 relativ kleine Werte hat, was zur Folge hat, daß die Kreisimpedanz relativ groß ist und damit auch die Amplitude relativ groß ist. Bei niedrigen Frequenzen hat die Kapazität 3 relativ große Werte, und die Kreisimpedanz und somit auch die Amplitude nehmen ab. Infolge der Auskoppelung am Verbindungspunkt zwischen den beiden Kapazitäten wirkt der aus diesen Kapazitäten gebildete Spannungsteiler dieser Amplitudenveränderung derart entgegen, daß sich am Verbindungspunkt eine etwa gleichbleibende Amplitude einstellt. Hinter der Koppelkapazität 5 gilt dies jedoch nicht mehr, da die Kapazität 5 zu hohen Frequenzen hin niederohmiger wird. Es ergibt sich also bereits am Verbindungspunkt 6 eine Abhängigkeit der Amplitude des Oszillatorsignals von der Frequenz. Diese Frequenzabhängigkeit der Amplitude wird noch deutlich verstärkt durch die induktive Eingangsimpedanz des Mischers. Der in der Figur dargestellte Mischer weist eine übliche Schaltung auf, in der ein in Basisschaltung arbeitender Transistor vorgesehen ist. Derartige Schaltungen weisen eine induktive Eingangsimpedanz auf. Infolge der induktiven Eingangsimpedanz des Mischers verstärkt sich die Frequenzabhängigkeit der ZF-Oszillatoramplitude weiter, da der Eingang des Mischers zu hohen Frequenzen hin hochohmiger wird, so daß die über die Koppelkapazität 5 dem Eingang des Mischers zugeführte Oszillatorspannung zu höheren Frequenzen hin eine noch stärker ansteigende Amplitude aufweist. Um dieser starken Frequenzabhängigkeit der Oszillatoramplitude am Eingang des Mischers entgegenzuwirken, ist am Eingang des Mischers der gegen Masse geschaltete Widerstand 7 vorgesehen. Der Wert dieses Widerstandes 7 ist etwa so gewählt, daß bei der höchsten, mittels der veränderbaren Kapazität 3 einstellbaren Oszillatorfrequenz die Spannungsamplitude des Oszillatorsignals am Eingang des Mischers durch Hinzuschalten des Widerstandes ungefähr halbiert wird. Dies hat zur Folge, daß das ZF-Oszillatorsignal über die Koppelkapazität 5 nunmehr auf eine Parallelschaltung des Mischer-Eingangs und des Widerstandes trifft. Die Widerstands-bzw. Impedanzwerte sind dabei so gewählt, daß die Gesamt-Impedanz vor allem durch den Wert des ohmschen Widerstandes 7 bestimmt wird. Auf diese Weise ist der negative Einfluß der Eingangsimpedanz des Mischers auf die Frequenzabhängigkeit der Oszillatoramplituden am Eingang des Mischers unterdrückt. Es ergibt sich selbst bei relativ großen Frequenzsprüngen, z. B. zwischen den Bändern I und III des VHF-Bereiches, lediglich eine um ca. den Faktor 2 in Abhängigkeit von der Frequenz - schwankende Amplitude des Oszillatorsignals am Eingang des Mischers.

## Ansprüche

Schaltungsanordnung für einen HF-Tuner, insbesondere Fernsehtuner, zur Ankopplung eines Mischers, der eine induktive Eingangsimpedanz aufweist, über eine Koppelkapazität an einen ZF-Oszillator, dadurch gekennzeichnet, daß hinter der Koppelkapazität dem Mischer-Eingang ein gegen Masse geschalteter ohmscher Widerstand vorgeschaltet ist, dessen Widerstandswert so gewählt ist, daß die am Eingang des Mischers anliegende Oszillator-Spannungsamplitude bei der höchsten Oszillatorfrequenz infolge des zugeschalteten Widerstandes etwa halbiert ist.